Europäisches Patentamt

European Patent Office

Office européen des brevets

(19)

(11) **EP 0 795 982 B1**

(12) **EUROPÄISCHE PATENTSCHRIFT**

(45) Veröffentlichungstag und Bekanntmachung des Hinweises auf die Patenterteilung:
**12.01.2005 Patentblatt 2005/02**

(51) Int Cl.[7]: **H04L 27/18**

(21) Anmeldenummer: **96106396.3**

(22) Anmeldetag: **24.04.1996**

(54) **Übertragunssystem mit Quadraturmodulation**

Transmission system with quadrature modulation

Système de transmission avec modulation en quadrature

(84) Benannte Vertragsstaaten:
**DE FR GB IT NL**

(30) Priorität: **11.03.1996 EP 96103816**

(43) Veröffentlichungstag der Anmeldung:
**17.09.1997 Patentblatt 1997/38**

(73) Patentinhaber: **Micronas GmbH**
**79108 Freiburg (DE)**

(72) Erfinder:
- **Temerinac, Miodrag, Prof.Dr.-Ing.**
**79194 Gundelfingen (DE)**
- **Witte, Franz-Otto, Dr.**
**79312 Emmendingen (DE)**

(56) Entgegenhaltungen:
**EP-A- 0 670 648      US-A- 4 528 526**
**US-A- 4 759 039      US-A- 4 879 726**

**Beschreibung**

Die Erfindung betrifft ein Übertragungssystem für ein digitales Signal, das in Symbole kodiert ist und mittels einer Quadraturmodulation von einem Sender in beliebiger Frequenzlage auf einen Empfänger übertragen wird. Daneben betrifft die Erfindung ferner einen an das Übertragungssystem angepassten Sender und Empfänger und schließlich eine angepasste Filterkombination. Ein derartiges Übertragungssystem ist aus EP-A-670648 bekannt.

Übertragungssysteme für digitale Signale sind in verschiedenen Ausführungen seit langem bekannt und werden wegen ihrer vorteilhaften Eigenschaften zunehmend auch im Bereich der Übertragung oder Speicherung von Signalen oder Daten des Unterhaltungs- oder Informationsbereiches verwendet. Das Hauptkennzeichen dieser Systeme ist, dass die zu übertragende Information in irgend einer Form seriell als digitalisiertes und kodiertes Signal vorliegt und dass dieses digitale Signal vor der Übertragung oder Speicherung grundsätzlich einer QPSK-Modulation (= Quaternary Phase Shift Keying) unterzogen wird. Danach schließt sich in der Regel noch eine Frequenzumsetzung für den Übertragungskanal oder das hochfrequente Übertragungsband an, die bei einer Speicherung entfällt. Auf der Empfängerseite findet die umgekehrte Signalverarbeitung statt, wodurch das ursprüngliche digitale Signal wieder zurückgewonnen wird. Daran schließt sich die weitere Signalverarbeitung im Empfänger an, die hier jedoch nicht von Belang ist. Das übertragene Signal, das den Übertragungskanal durchläuft, ist ein kontinuierliches, analoges Signal, das die digitale Information in irgend einer kodierten Form als Modulation enthält. Wesentlich ist dabei das Vorhandensein von möglichst sicheren Quantisierungsbereichen bei dieser Modulation, um eine möglichst hohe Störsicherheit des Übertragungssystems zu erreichen. Das bereits angegebene QPSK-Modulationsverfahren und seine Varianten vereinen hierfür hohe Übertragungssicherheit und hohe Anpassungsfähigkeit. Die zu übertragenden Signale können dabei von schmalbandigen Mess- oder Tonsignalen bis hin zu breitbandigen Video- oder hochauflösenden Farbfernsehsignalen reichen. Einige Beispiele für bekannte terrestrische oder satellitenbezogene Übertragungssysteme, die nach diesem Verfahren vorgehen, sind: DVB = Digital Video Broadcasting, DAB = Digital Audio Broadcasting, ADR = Astra Radio und World Space Radio. Zu bekannten Verfahren mit Quadraturmodulation gehören noch: BPSK = Binary Phase Shift Keying, QAM = Quadrature Amplitude Modulation oder VSB = Vestigial Side Band Modulation.

Die Quadraturmodulation lässt sich gleichsam als ein Zeiger beschreiben, der mit der Trägerfrequenz in einer gedachten Ebene rotiert, die von einer I- und einer dazu senkrecht stehenden Q-Koordinate gebildet wird. Ohne Modulation ist die Rotationsfrequenz konstant und die Phase nimmt daher konstant zu. Dies definiert eine Bezugsphase, die mit dem zu übertragenden Signal moduliert wird. Bei analogen Signalen ist jeder Phasenwert möglich. Bei digitalen Signalen erfolgt eine Quantisierung, durch die nur bestimmte Phasenbereiche zulässig und damit unterscheidbar sind, beispielsweise die vier Quadranten. Störungen, die kleiner bleiben als die jeweiligen Quantisierungsgrenzen, haben keine Auswirkungen. Durch die Vorgabe der Trägerfrequenz kann das QPSK-Modulationsverfahren an den zu übertragenden Frequenzbereich des Signals angepasst werden. Unter Umständen wird auch noch die Zeigerlänge verändert, beispielsweise beim QAM-Verfahren, wodurch eine unabhängige weitere Information übertragen werden kann.

Bei der Entwicklung eines Übertragungssystems ist sowohl eine Optimierung des Gesamtsystems im Hinblick auf die Übertragungseigenschaften als auch im Hinblick auf den erforderlichen Aufwand der zu verwendenden Sender und Empfänger zu beachten. Dabei ist es wichtig, ob das System bidirektional ist oder ob es im wesentlichen nur aus einem Sender und einer Vielzahl von Empfängern, wie bei einem üblichen Rundfunksystem, besteht. In letzterem Fall ist es sinnvoll, das System asymmetrisch auszubilden, eventuell sogar mit einem höheren Aufwand für den Sender, wenn dadurch die Übertragungseigenschaften verbessert und/oder die Empfänger vereinfacht werden können.

Es ist daher Aufgabe der Erfindung, ein Übertragungssystem für digitale Signale anzugeben, das gegenüber bekannten Systemen eine Verbesserung der Übertragungseigenschaften und insbesondere eine Reduktion des Empfängeraufwandes ermöglicht.

Eine weitere Aufgabe besteht darin, für das Übertragungssystem nach der Erfindung einen angepassten Sender sowie einen angepassten Empfänger anzugeben.

Schließlich besteht eine Aufgabe darin, für das Übertragungssystem nach der Erfindung eine vorteilhafte Filterkombination anzugeben.

Die Hauptaufgabe der Erfindung wird durch ein Übertragungssystem nach Anspruch 1, einem Sender nach Anspruch 3 und einem Empfänger nach Anspruch 4 gelöst

Die Vereinfachung im Empfänger resultiert aus der erfinderischen Erkenntnis, dass bei einer bestimmten Verzögerung der einen Quadratursignal-Komponente im Sender das Impulsformfilter im Empfänger durch eine einfache IIR-Struktur mit Allpässen ersetzt werden kann, ohne dass ein zusätzlicher Gruppenlaufzeitausgleich für eine der beiden Quadratursignal-Komponenten erforderlich wird.

Die Erfindung und weitere vorteilhafte Ausgestaltungen werden nun anhand der Figuren der Zeichnung näher erläutert:

Fig. 1    zeigt als Blockschaltbild einen üblichen Sender mit Empfänger,
Fig. 2    zeigt die Parallelisierung der Daten im Sender,

| | |
|---|---|
| Fig. 3 | zeigt eine Tabelle zur Definition von Symbolen |
| Fig. 4 | zeigt ein QPSK-Zeigerdiagramm, |
| Fig. 5 | zeigt ein Quadratursignalpaar und einen vorteilhaften Abtasttakt, |
| Fig. 6 | zeigt schematisch eine digitale Signalverarbeitung im Empfänger, |
| Fig. 7 | zeigt einen Sender und Empfänger nach der Erfindung, |
| Fig. 8 | zeigt im Zeitdiagramm die Übertragungsfunktion des Empfängerfilters, |
| Fig. 9 | zeigt im Zeitdiagramm die Übertragungsfunktion des Senderfilters, |
| Fig.10 | zeigt im Zeitdiagramm die gefaltete Übertragungsfunktion des Sender- und Empfängerfilters, |
| Fig. 11 | zeigt im Frequenzdiagramm den Dämpfungsverlauf des Empfängerfilters und eines zugehörigen idealen Senderfilters, |
| Fig. 12 | zeigt den Dämfpfungsverlauf des realen Senderfilters, |
| Fig. 13 | zeigt schematisch als Augendiagramm die Grenzkurven der demodulierten Quadratursignal-Komponenten im Empfänger, |
| Fig. 14 | zeigt eine IIR-Filterstruktur und |
| Fig. 15 | zeigt eine Allpaßstruktur. |

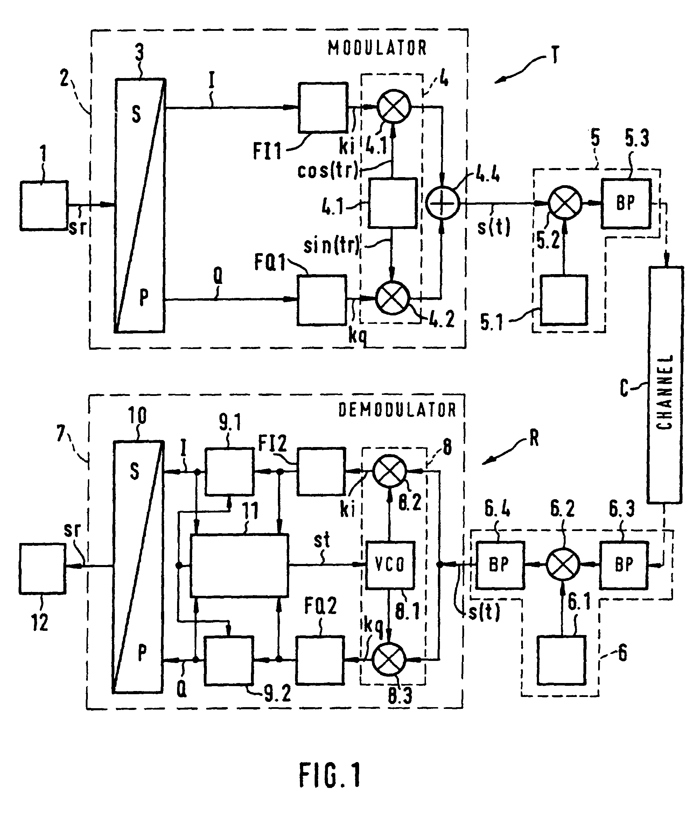

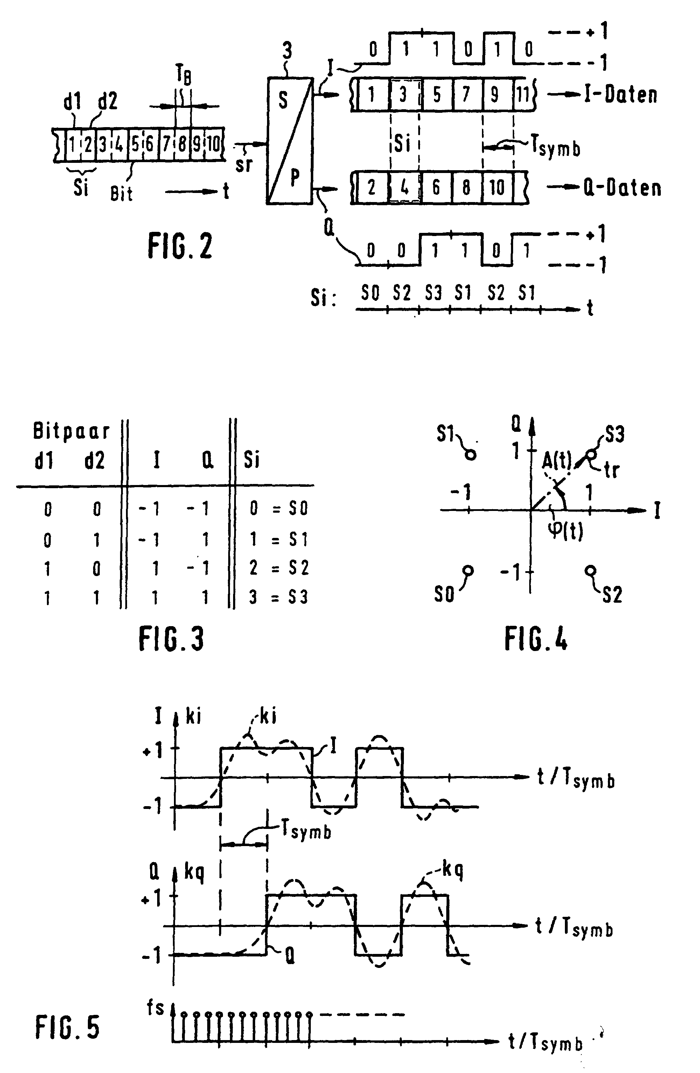

In Fig. 1 ist einem Sender T aus einer Quelle 1 ein digitaler Datenstrom als digitales Signal sr zugeführt. Die für die Quadraturmodulation wesentlichen Teile befinden sich in einem Modulator 2, der einen Seriell/Parallel-Umsetzer 3 enthält, der aus dem digitalen Signal sr ein I- und ein dazu paralleles Q-Signal, jeweils als ein Datenstrom, bildet. Zur Bandbegrenzung werden beide Datenströme I, Q jeweils einem Impulsformfilter FI1, FQ1 zugeführt, die danach üblicherweise als eine Inphase- bzw. Quadraturphase-Komponente ki, kq bezeichnet werden und mittels eines Sender-Quadraturmischers 4 einen Quadraturträger tr modulieren. Der Träger tr ist mittels eines sin/cos-Generators 4.1 gebildet, dessen cos- und sin-Komponenten cos(tr), sin(tr) einem ersten bzw. zweiten Mischer 4.2, 4.3 zugeführt sind. Der Träger tr rotiert im Zeigerdiagramm (vergl. Fig. 4) mit der Trägerfrequenz $f_{tr}$. Die Ausgangssignale der beiden Mischer 4.2, 4.3 sind mittels eines Addierers 4.4 addiert und bilden ein moduliertes Signal s(t), das mit einem ein- oder mehrstufigen Frequenzumsetzer 5 in die Bandlage eines Übertragungskanals C gebracht wird. Vom Umsetzer 5 sind ein Generator 5.1, ein Mischer 5.2 und ein ausgangsseitiges Bandfilter 5.3 dargestellt. Das modulierte Signal s(t) ist ein kontinuierliches, analoges Signal, das auf dem Übertragungsweg C von Fremd- und Rauschsignalen überlagert wird. Die durch Interferenzen oder Rauschen entstehenden Störwirkungen sind bekanntlich am geringsten, wenn im Sender T und Empfänger R Impulsformfilter verwendet werden, die sowohl dem Rauschanpassungs- als auch dem Nyquistkriterium genügen.

Der Empfänger R ist funktionsmäßig spiegelbildlich zum Sender T aufgebaut. Das empfangene hochfrequente Signal ist mittels eines Frequenzumsetzers 6, der einen Generator 6.1, einen Mischer 6.2 und zwei Bandpässe 6.3, 6.4 enthält, wieder als ein analoges Signal s(t) in ein niederes Frequenzband oder Basisband umgesetzt, wo es in einem Demodulator 7 entweder analog oder digital demoduliert und dekodiert werden kann.

Zunächst wird das analoge Signal s(t) im Demodulator 7 mittels eines Empfänger-Quadraturmischers 8 wieder in seine Inphase- und Quadraturphase-Komponente ki, kq zerlegt. Dies kann im Quadraturmischer analog durch Mischung mit einem sinund cos-Signal aus einem sin/cos-Generator 8.1 erfolgen. Die Quadraturmischung kann aber auch rein digital erfolgen, dann werden die digitalisierten Signalwerte bei jedem Abtasttakt mit einem digitalen sin- und cos-Wert multipliziert, die beispielsweise zu jedem Winkelwert aus einer gespeicherten sin/cos-Tabelle abrufbar oder über ein geeignetes Rechenverfahren bestimmbar sind. Die Mischer 8.2, 8.3 sind jedoch besonders einfach digital zu realisieren, wenn der Generator 8.1 zu festen Abtastzeitpunkten die Werte +1, 0, -1, 0, +1, 0, ... usw als Quadraturträgerwerte abgibt. In beiden Fällen muß der Generator 8.1 starr mit der Bezugsphase des Senders über eine Phasenverriegelungsschleife (= PLL) verkoppelt sein. In jedem Signalpfad folgt dann ein Impulsformfilter FI2 bzw. FQ2 und ein Inphase- bzw. ein Quadraturphase-Detektor 9.1, 9.2. Schließlich wird das I- und Q-Signal mittels eines Parallel/Seriell-Umsetzers 10 wieder zu einem einzigen Datenstrom sr zusammengefügt. Die weitere Verarbeitung findet in einer Verarbeitungsstufe 12 statt.

Im Demodulator 7 ist als Teil der PLL eine Taktrückgewinnungseinrichtung 11 vorhanden, die aus dem I- und Q-Signal ein Steuersignal st bildet, das den in der Frequenz steuerbaren Generator 8.1 (= VCO) in der Frequenz und Phase auf die Bezugsphase einrastet. Bei einem digitalen Demodulator liefert die Taktrückgewinnungseinrichtung 11 auch den Abtasttakt fs, dessen Frequenz in der Regel ein ganzzahliges Vielfaches der Symbolfrequenz fsymb ist.

In Fig. 2 ist die Parallelisierung des ursprünglichen Datenstromes sr anhand einer Datenfolge dargestellt. Der Seriell/Parallel-Umsetzer 3 verteilt die ursprüngliche Bitfolge 1, 2, 3, 4, ... alternativ auf zwei Signalpfade I, Q, so daß von den ursprünglichen Bitpaaren d1, d2 die ungeradzahligen Bits einen I- und die geradzahligen einen Q-Datenstrom mit jeweils der Datenrate $f_{Bit}/2$ bilden. Das Bitpaar d1, d2 bildet dabei ein "Symbol" Si, das als solches durch das jeweilige Modulationsverfahren kodiert wird. Ein Bitpaar d1,d2 kann vier verschiedene logische Zustände aufweisen, denen somit vier verschiedene Symbole S0, S1, S2, S3 zukommen, vergleiche die Tabelle von Fig. 3. Den Symbolen Si entspicht eine Symbolrate oder Symbolfrequenz fsymb, die nur halb so groß ist wie die Bitrate $f_{Bit}$ des Datenstromes sr. Es können auch mehr als zwei ursprüngliche Bits, beispielsweise vier, sechs oder acht, zu einem Symbol zusammengefaßt werden, dann erhöht sich die mögliche Anzahl der Symbole, die Symbolrate wird jedoch noch niedriger. Je niedriger die Symbolrate ist, desto niedriger kann die Verarbeitungsfrequenz im Sender und Empfänger sowie auch die Frequenz des Quadraturträgers gewählt werden.

In Fig. 4 ist ein Zeigerdiagramm für eine QPSK-Modulation dargestellt. Den vier möglichen Symbolen Si sind die vier Quadranten des Einheitskreises zugeordnet. Der Zeiger entspricht dem Träger tr, dessen momentane Rotationsposition im I/Q-Koordinatensystem durch den Winkel $\varphi(t)$ und die Amplitude A(t) eindeutig definiert ist.

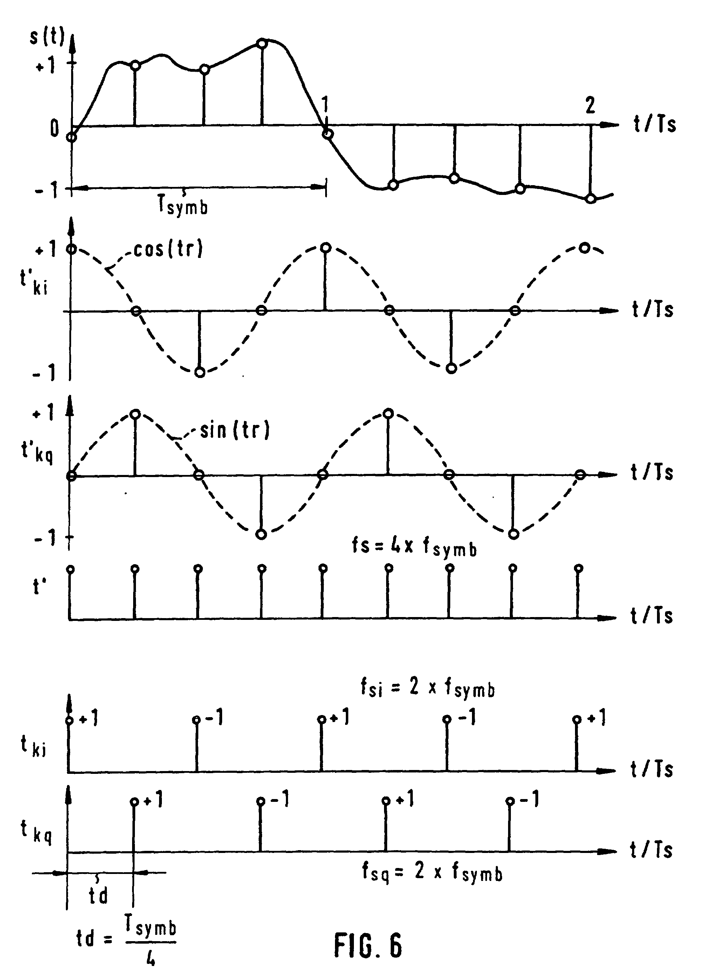

In Fig. 5 ist ein Beispiel für den idealisierten Zeitverlauf des I- und Q-Signals im Sender und Empfänger dargestellt, die entspechend den zugehörigen Symbolen Si theoretisch zwischen den normierten Signalwerten +1 und -1 unendlich steile Impulsflanken aufweisen müßten - das Spektrum wäre dann unendlich lang. Um die erforderliche Bandbreite so weit wie möglich zu reduzieren, werden mittels der bereits genannten Impulsformfilter die Flanken auf vorgegebene Weise verrundet, wodurch aus der Impulsfolge die Inphase- und die Quadraturphase-Komponente ki, kq gebildet werden. Die dargestellten Komponenten ki, kq treten sowohl im Sender als auch etwas modifiziert im Empfänger auf und können dort gegebenenfalls durch einen Abtasttakt fs vor oder nach der Quadraturmischung digitalisiert werden. Wie weit dabei der Abtasttakt in der Frequenz höchstens reduziert werden kann, geht aus Fig. 6 hervor.

Fig. 6 zeigt schematisch wie im Empfänger R aus dem empfangenen analogen Signal s(t) mittels einer geeigneten Abtastung wieder die einzelnen Quadratursignal-Komponenten ki, kq gewonnen werden können. Fig. 6 zeigt im zeitlich gleichen Maßstab das analoge Signal s(t) mit der zugehörigen cos- und sin-Komponente cos(tr) bzw. sin(tr) des Trägers tr, die als gestrichelte Kurvenverläufe dargestellt sind. Die Zeitachse t ist auf die Symbolperiode $T_{symb}$ (= $T_s$ = Ts) normiert. In der vierten Zeile sind die Abtastzeitpunkte t' des Abtasttaktes fs dargestellt, dessen Abtastzeitpunkte t' entsprechend Fig. 4 mit den I/Q-Koordinatendurchgängen der Bezugsphase verkoppelt sind und damit auch die auf den Träger tr bezogenen Abtastzeitpunkte $t'_{ki}$ bzw. $t'_{kq}$ der cos- bzw. sin-Trägerkomponente festlegen. Dadurch ergeben sich eine vorteilhafte Abtastrate fs und eine vorteilhafte Trägerfrequenz $f_{tr}$, die mit der Symbolfrequenz fsymb ganzzahlig verkoppelt sind: fs = 4 $\times$ $f_{symb}$ und $f_{tr}$ = $f_{symb}$. Dann ergeben sich wie bereits angegeben sehr einfache Multiplikationsfaktoren für die empfängerseitige Quadraturmischung, nämlich nur die Werte: +1, 0 und -1. Die zugehörigen Mischer sind digital und analog auf einfache Weise durch Torschaltungen und Negierstufen zu realisieren.

Wenn eine Abtastung zum Zeitpunkt des jeweiligen I/Q-Koordinatendurchgangs erfolgt, dann kann die Quadraturmischung im Empfänger nach der Erfindung weiter vereinfacht werden, denn die Multiplikation mit dem Faktor "0", ergibt selbstverständlich als Signalwert wieder "0". Dieser "0"-Signalwert kann für die weitere Verarbeitung einfach ausgelassen werden, wie dies bei einfachen Abtastraten-Reduzierungsstufen, die auch als Dezimierungsstufen bezeichnet werden, durch das Auslassen von einzelnen Daten und anschließender Tiefpaßfilterung üblich ist. Bei quadraturmodulierten Signalen entsteht systembedingt durch die Auslassung kein Informationsverlust.

In den letzten beiden Zeilen sind nur noch die mit den Multiplikationsfaktoren +1 und -1 verkoppelten Abtasttakte fsi bzw. fsq zu den Abtastzeitpunkten $t_{ki}$ bzw. $t_{kq}$ für die Inphase-Komponente ki und die Quadraturphase-Komponente kq dargestellt. Die Abtastzeitpunkte $t_{ki}$ bzw. $t_{kq}$ sind dabei gegeneinander um das Zeitintervall td verschoben, wobei td = 1/4 $\times$ $T_{symbol}$ ist.

Die Frequenz des Inphase-Abtasttaktes fsi und die Frequenz des Quadraturphase-Abtasttaktes fsq sind damit zwar gleich:

$$fsi = fsq = 2 \times fsymb,$$

die Phasen sind jedoch unterschiedlich, so daß die Abtastwerte $t_{ki}$ bzw. $t_{kq}$ wie bereits angegeben zeitlich um Tsymb/4 versetzt anfallen.

Die Ermittlung der Momentanposition $\varphi(t)$ des resultierenden Zeigers tr(t) und damit die Ermittlung der beiden Quadratursignal-Komponenten ki, kq ist mit der erforderlichen Genauigkeit nur möglich, wenn zu dem jeweiligen Abtastzeitpunkt t sowohl ein Inphase- als auch ein Quadraturphase-Abtastwert tatsächlich zur Verfügung steht. Das ist bei den alternierenden Abtastfolgen $t_{ki}$, $t_{kq}$ von Fig. 6 ohne Interpolation nicht möglich.

Die hierbei üblicherweise zu verwendeten FIR-Interpolationsfilter, die auch die Bedingungen des Nyquistkriteriums und der Rauschanpassung erfüllen müssen, sind sehr aufwendig, lassen sich aber bisher nicht vermeiden. Gemäß der Erfindung wird für die Interpolation jedoch ein wesentlich einfacheres IIR-Filter vorgeschlagen, das die genannten Bedingungen ebenfalls erfüllt. Die Voraussetzung ist dabei, daß die eine Quadratursignal-Komponente ki bzw. kq im Sender um ein Zeitintervall td verzögert wird, das insbesondere einem Viertel der Symbolperiode Tsymb gleich ist.

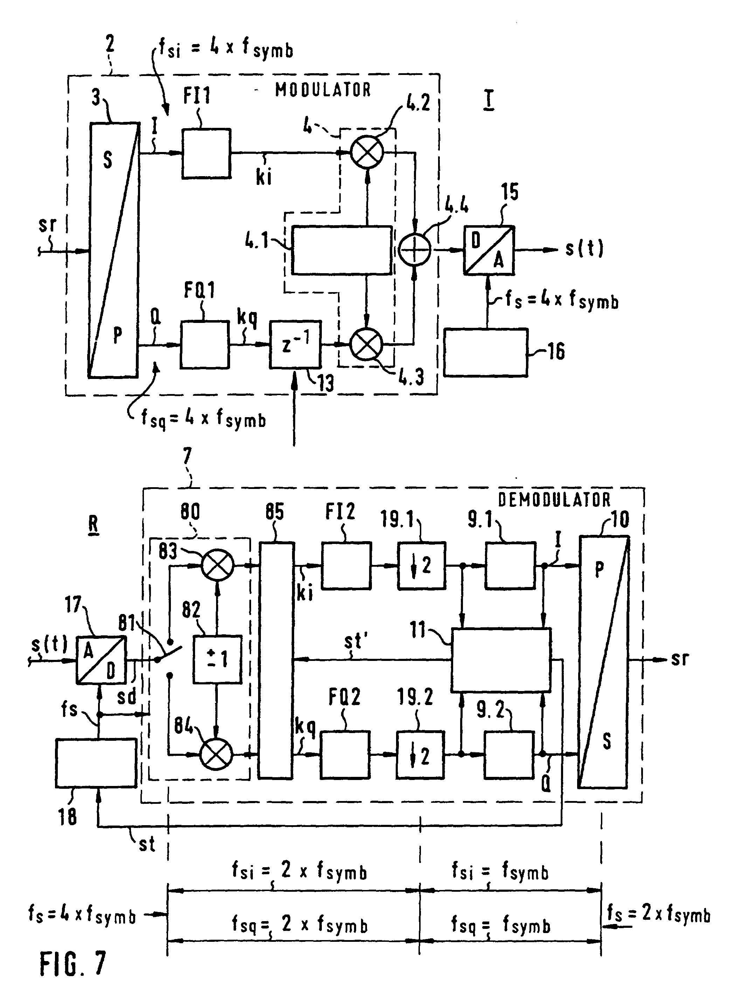

In Fig. 7 ist ist ein Ausführungsbeispiel für den Sender T und Empfänger R nach der Erfindung dargestellt. Der Sender T enthält in seinem Blockschaltbild bis auf einen Verzögerer 13 im Quadratur-Signalpfad Q die gleichen Funktionseinheiten wie im Blockschaltbild von Fig. 1. Durch die Verwendung der gleichen Bezugszeichen und die grundsätzlich gleiche Funktionsweise erübrigt sich eine nochmalige Erörterung der gesamten Senderschaltung T. Das Verzögerungsintervall td durch den Verzögerer 13 hat den Wert td = Tsymb/4 . Mit diesem Wert können wie angegeben auf der Empfängerseite R umfangreiche Impulsformfilter durch sehr einfache Filterstrukturen ersetzt werden. Dies hat natürlich auch eine Rückwirkung auf die Struktur und Dimensionierung der Impulsformfilter FI1, FQ1 im Sender, wie später ausführlich dargelegt wird. Die Signalverarbeitung im Sender T kann analog oder digital erfolgen. Bei einer digitalen Verarbeitung sollten die Frequenzen der Verarbeitungstakte fsi, fsq mindestens die vierfache Symbolfrequenz oder Vielfache davon sein.

In Fig. 7 ist ein digitales Ausführungsbeispiel für den Sender T schematisch dargestellt. An den digitalen Modulator 2 schließt sich ein Digital/Analog-Umsetzer 15 an, dem passend zur internen digitalen Signalverarbeitung als Umwandlungstakt fs der vierfache Symboltakt fs = 4 × fsymb aus einem entsprechenden Generator 16 zugeführt ist, dessen Verkopplung mit dem Bittakt $f_{Bit}$ des Datenstromes sr in Fig. 7 nicht gezeigt ist. Durch diesen Umsetzer 15, dessen Ausgangssignal das analoge Signal s(t) ist, wird nochmals deutlich, daß die eigentliche Übertragung analog erfolgt. Die Hochfrequenzumsetzung auf der Sender- und Empfängerseite ist nicht dargestellt.

Das Blockschaltbild des Empfängers R in Fig. 7 zeigt ebenfalls einen sehr ähnlichen Grundaufbau wie der Empfänger in Fig. 1. Die gleichen Funktionseinheiten sind mit den gleichen Bezugszeichen gekennzeichnet, so daß die Übereinstimmungen leicht erkennbar sind. Es wird auch hier auf die vorausgehende Beschreibung verwiesen. Das empfangene und in der Frequenz heruntergemischte analoge Signal s(t) wird mittels eines Analog/Digital-Umsetzers 17 digitalisiert und bildet einen Datenstrom sd, wobei der Digtalisierungstakt fs aus einem Taktgenerator 18 stammt, der mit einer Taktrückgewinnungseinrichtung 11 gekoppelt ist. Der Digitalisierungstakt wäre bei einer üblichen digitalen Verarbeitung zunächst beliebig, sofern das Abtasttheorem bezüglich der Bandbreite des empfangenen Signals s(t) nicht verletzt wird. Für die bevorzugte digitale Empfängerrealisierung ist jedoch der Digitalisierungstakt fs nicht mehr frei vorgebbar, sondern seine Frequenz sollte möglichst genau viermal so groß sein wie die Symbolfrequenz fsymb. Dies ergibt sich aus den Ausführungen zu Fig. 6 und den Erläuterungen zur Filterrealisierung, wenn ein geschalteter Empfänger-Quadraturmischer mit dem einfachen Schaltverhalten +1, -1 verwendet werden soll. Dadurch ergibt sich eine zugehörige Abtastfrequenz fsi, fsq der beiden Quadratur-Komponenten ki, kq mit jeweils fs = 2 × fsymb . Dies ist eine zwingende Voraussetzung für die Realisierung der Empfänger-Filter mittels IIR-Filterstrukturen, vergl. die späteren Ausführungen hierzu, insbesondere die dort angegebene Gleichung (2). Ein Quadraturmischer 80, 85 in einem Demodulator 7 arbeitet nach diesem Prinzip.

Dem mit dem Taktgenerator 18 gekoppelten Quadraturmischer 80 ist ein Umschalter 81 als Demultiplexer zugeordnet, der die Ausgangsdaten des Analog/Digital-Umsetzers 17 alternierend auf einen I- und Q-Datenpfad verteilt. Der Umschalter 81 entspricht der Umkehrung des Addierers 4.4 im Sender T von Fig. 7. Ein Generator 82 für den Quadraturträger tr, der mit einem I- und Q-Mischer 83, 84 verbunden ist, enthält eine Datenquelle 82, die alternierend die Werte +1 und -1 an die Mischer 83, 84 gibt. Diese müssen die zugeführten Daten entweder unverändert beibehalten oder negieren, beides ist mit den üblichen Binärzahlensystemen, insbesondere im Zweierkomplement-Zahlensystem, leicht zu realisieren. Die Quadraturmischung im Demodulator 7 enthält außer dem Mischer 80, einem Grobquadraturmischer, auch einen Feinquadraturmischer 85, der nur sehr niedere Trägerdifferenzfrequenzen verarbeitet. Dadurch werden die Inphase- und Quadraturphase-Komponente ki, kq nach dem Grobmischer 80 mit einem sich nur langsam ändernden cos- und sin-Wert multipliziert, was einer zusätzlichen Winkeldrehung des resultierenden Trägers oder Zeigers tr entspricht. Durch diese Aufteilung kann die Einstellung der relativ hohen Trägerfrequenz im schnellen Mischer 80 in relativ groben Frequenzschritten erfolgen, ohne daß dies zu Ungenauigkeiten bei der Auswertung kommt. Die Nachführung des Grob- bzw. Feinquadraturumsetzers 80 bzw. 85 erfolgt durch ein Steuersignal st bzw. st' aus der Taktrückgewinnungseinrichtung 11.

An die beiden Quadraturmischer 80, 85 schließt sich eine Inphase- bzw. ein Quadraturphase-Impulsformfilter FI2, FQ2 an, dem jeweils eine Dezimierungsstufe 19.1 bzw. 19.2 folgt, in der die jeweilige Datenrate fsi, fsq nochmals um den Faktor 1/2 verkleinert wird. Schließlich können mittels zwei Detektorstufen 9.1, 9.2 wieder die ursprünglichen Symbole Si gebildet werden, die durch einen Parallel/Seriell-Umsetzer 10 wieder zu einem seriellen Datenstrom sr zusammengesetzt werden. Die jeweiligen Abtastraten sind bei den jeweiligen Verarbeitungsabschnitten des Senders T und Empfängers R in Fig. 7 der Klarheit wegen mit angegeben.

Im Blockschaltbild des Empfängers R von Fig. 7 sind keinerlei Verzögerer zu erkennen, die eigenlich infolge der Verzögerung im Sender T zu erwarten gewesen wären. Die Ursache hierfür liegt in der erfinderischen Realisierung der Empfänger-Impulsformfilter FI2, FQ2, die hierfür IIR-Filterstrukturen mit jeweils zwei Allpässen vorsieht. Diese Filter erfüllen in Verbindung mit den zugehörigen senderseitigen Filtern FI1, FQ1 sowohl das Rauschanpassungs- als auch das Nyquistkriterium. In dem nachfolgenden Teil der Beschreibung wird auf den Nachweis dieser Eigenschaften, die entsprechende Filterstrukturen und ihre grundlegende Dimensionierung ausführlich am Beispiel eines Filterpaares F1, F2 eingegangen, das stellvertretend für das Inphase-Filterpaar FI1, FI2 oder das Qudraturphase-Filterpaar FQ1, FQ2 stehen kann. Diese Filter F1, F2 weisen unterschiedliche Filterstrukturen auf. Die Übertragungseigenschaften der einzelnen Filter für sich betrachtet sind asymmetrisch. Wie gezeigt werden wird, müssen die Impulsantworten der beiden Teilfilter F1, F2 jedoch zeitlich spiegesymmetrisch zueinander sein.

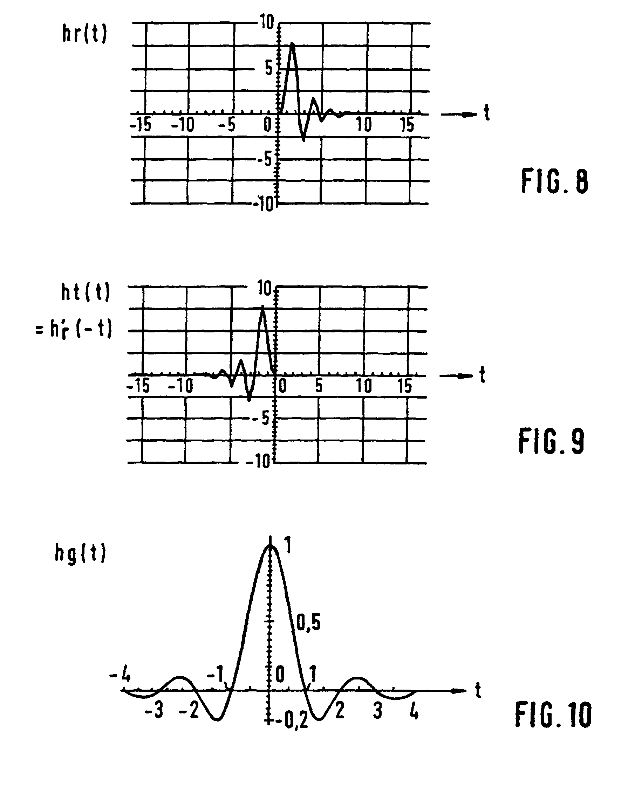

Die nachfolgenden Ausführungen beziehen sich auf die beiden asymmetrischen Filterpaare FI1, FI2 und FQ1, FQ2. Das senderseitige Filter wird im folgenden vereinfacht als erstes Filter F1 und das empfängerseitige als zweites Filter F2 bezeichnet. Für die Erfindung ist eine asymmetrische Filterkombination F1, F2 zu realisieren. Beispiele für die Impulsantwort h(t) einer asymmetrischen Filterkombination F1, F2 sind in Fig. 9 für das senderseitige Filter F1 und Fig. 8 für das empfängerseitige Filter F2 angegeben. Beide Zeitverläufe sind bezüglich der Zeitachse t = 0 zueinander spiegelsymmetrisch. Die sich in den negativen Zeitbereich erstreckende Impulsantwort von Fig. 9 ist durch eine entsprechende Vorverzögerung der Impulsantworten von Fig. 9 und/oder Fig. 8 zu realisieren, ohne daß das Kausalitätsgesetz verletzt wird. Das Zusammenwirken der beiden asymmetrischen Filter F1, F2 wird durch die gemeinsame Impulsantwort hg(t) in Fig. 10 dargestellt, die sich aus der Faltung der Impulsantwort von Fig. 8 und Fig. 9 ergibt.

Für die weitere Betrachtung ist es erforderlich, daß das Nyquist- und das Rauschanpassungskriterium ausführlicher anhand der komplexen Übertragungsfunktionen H(z) betrachtet werden. In den folgenden Formeln wird eine Indizierung in der üblichen Form nur vorgenommen, wenn andernfalls Mißverständnisse entstehen könnten. Die Filterkombination F1, F2 hat eine gemeinsame Übertragungsfunktion Hg(z), die in eine Übertragungsfunktion Ht(z) für das Senderfilter F1 und Hr(z) für das Empfängerfilter F2 aufgeteilt ist. Aus der Faltung der beiden Teilfilter F1, F2 ergibt sich die Übertragungsfunktion Hg(z) für die Filterkombination F1, F2:

$$Hg(z) = Ht(z) \times Hr(z), \hspace{3cm} \text{Gleichung (1)}$$

Die folgenden Überlegungen gelten unter der Voraussetzung, daß der für das Empfänger-Filter F2 wirksame Abtasttakt fsi bzw. fsq, der in Fig. 7 durch den Analog/Digital-Umsetzer 17 und den Demultiplexer 81 bestimmt wird, in der Frequenz doppelt so hoch ist wie die Symbolfrequenz fsymb, also fsi = fsq = 2 x fsymb . Der Vereinfachung wegen wird im Folgenden nur noch im Zweifelsfall zwischen dem Inphase-Abtasttakt fsi bzw. Quadraturphase-Abtasttakt fsq beim Empfänger-Filter F2 unterschieden, statt dessen wird verallgemeinernd für fsi bzw. fsq der für dem jeweiligen Verarbeitungsbereich zugeordnete Abtasttakt fs oder die Abtastfrequenz fs angegeben..

Unter der Annahme

$$fs = 2 \times fsymb, \hspace{3cm} \text{Gleichung (2)}$$

wird die Realisierung der empfängerseitigen Impulsformfilter und die Formulierung der zu erfüllenden Kriterien besonders einfach, wie folgende Ausführungen zeigen. Dann hat das Nyquist-Kriterium folgende allgemeine Form:

$$Hg(z) + Hg(-z^*) = 1 \hspace{3cm} \text{Gleichung (3)}$$

wobei

$$z = Exp(j \times 2\pi \times f/f_s)$$

ist.

Für eine optimale Rauschanpassung muß zwischen dem ersten und zweiten Filter F1, F2 folgende Beziehung bestehen:

$$Ht(z) = Hr(z^*) \hspace{3cm} \text{Gleichung (4)}$$

Des weiteren ist zur Unterdrückung von Nachbarkanalstörungen im jeweiligen Sperrbandbereich von F1, F2 eine ausreichende Dämpfung $a_{min}$ gefordert. Der Beginn des Sperrbandes wird gemäß den Gleichungen (5) und (6) üblicherweise mit Hilfe des "Roll-off"-Faktors r definiert:

$$\left| Ht(Exp(j \times 2\pi \times f/f_s)) \right| \leq a_{min} \hspace{1cm} \text{für } f \geq 0{,}5 \times fsymb \times (1 + r) \hspace{0.5cm} \text{Gleichung (5)}$$

$$\left| Hr(Exp(j \times 2\pi \times f/f_s)) \right| \le a_{min} \quad \text{für } f \ge 0{,}5 \times fsymb \times (1 + r) \qquad \text{Gleichung (6)}$$

Diese Bedingungen werden wie bereits angegeben durch die als Impulsformfilter weithin eingesetzten "raised-cosin"- und Gauß-Filter erfüllt. Der Nachteil dieser Filterstrukturen ist jedoch der beträchtliche Aufwand auf der Sender- und Empfängerseite.

Der Erfindung liegt die Erkenntnis zugrunde, daß eine Empfänger-Filterstruktur mit zwei parallelgeschalteten Allpässen A1, A2 ebenfalls die Kriterien gemäß den Gleichungen (2), (3), (5) und (6) erfüllen kann. Die zugehörige komplexe Übertragungsfunktion hat das folgende Aussehen:

$$Hr(z) = 1/2 \times (A1(z^2) + z^{-1} \times A2(z^2)) \qquad \text{Gleichung (7)}$$

Die komplexe Übertragungsfunktion der beiden Allpaßfilter A1, A2 hat die Form:

$$H_{Allpaß}(z) = A_i(z) =$$

$$= (a_m + a_{m-1} \times z^{-1} + ... + a_1 \times z^{-m+1} + z^{-m}) / (1 + a_1 \times z^{-1} + ... + a_m \times z^{-m}) \qquad \text{Gleichung (8)}$$

Wird die Gleichung (8) anstatt auf die Variable z auf die invertierte Variable z* = 1/z bezogen, dann ergibt sich folgende Umformung für die Gleichung (8):

$$A_i(z^*) = 1 / A_i(z) \qquad \text{Gleichung (8A)}$$

Wie sich nachweisen läßt, erfüllt eine Filterkombination F1, F2, die sowohl im Empfängerfilter F2 als auch im entsprechenden Senderfilter F1 mittels Allpässen realisiert ist, theoretisch die geforderte Nyquist-Bedingung.

Ausgehend von Gleichung (7) wird über die Rauschanpassungsbedingung von Gleichung (4) aus der Übertragungsfunktion Hr(z) des Empfängerfilters F2 die zugehörige Übertragungsfunktion Ht(z) des Senderfilters F1 gebildet.

$$Ht(z) = 1/2 \times ( 1 / A1(z^2) + z / A2(z^2)) \qquad \text{Gleichung (8b)}$$

Die gemeinsame Übertragungsfunktion Hg(z) dieser Filterkombination F1, F2 mit Allpässen gibt sich aus der Faltung der einzelnen Übertragungsfunktionen gemäß Gleichung (7) und Gleichung (8b):

$$Hg(z) = 1/2 \times (A1(z^2) + z^{-1} \times A2(z^2)) \times 1/2 \times (1/A1(z^2) + z/A2(z^2)) \qquad \text{Gleichung (9)}$$

Die Faltung, die über eine komplexe Multiplikation der beiden Übertragungsfunktionen Hr(z) und Ht(z) durchzuführen ist, führt schließlich zur folgenden Gleichung (10):

$$Hg(z) = 1/2 + 1/4 \times (z \times A1(z^2) / A2(z^2) + z^{-1} \times A2(z^2) / A1(z^2)) \qquad \text{Gleichung (10)}$$

Wendet man auf Gleichung 10 das Nyquist-Kriterium aus Gleichung (3) formal an, wobei insbesondere die Übertragungsfunktion Hg(-z*) zu bilden ist, dann ergibt sich schließlich

$$Hg(z) + Hg(-z^*) = 1 + 0 \qquad \text{Gleichung (11)}$$

Obwohl die Gleichung (11) über die Übertragungsfunktion von Filtern mit Allpässen hergeleitet ist, zeigt sie das gleiche Aussehen wie Gleichung (3), die ganz allgemein für das Nyquist-Kriterium steht. Leider ist das konjugiert komplexe Filter gemäß Gleichung (4) instabil und mit Allpässen in dieser Form nicht kausal realisierbar. Durch die Invertierung des als stabil vorausgesetzten Empfängerfilters F2 werden Pole und Nullstellen vertauscht, wodurch die Pole des Senderfilters F1 in der komplexen Frequenzebene außerhalb des Einheitskreises zu liegen kommen. Dies gilt jedoch nur für eine mathematisch exakte IIR-Realisierung des Senderfilters. Es ist jedoch leicht möglich, durch eine FIR-Näherung ein Senderfilter zu entwerfen, das die geforderten Bedingungen mit einer nur durch den Filteraufwand begrenzten Genauigkeit erfüllt. Der Entwurf dieses Filters basiert wie bereits angegeben auf der zeitgespiegelten und verzögerten Impulsantwort hr'(-t) = ht(t) des Empfängerfilters F2 entsprechend Fig. 8 und Fig. 9.

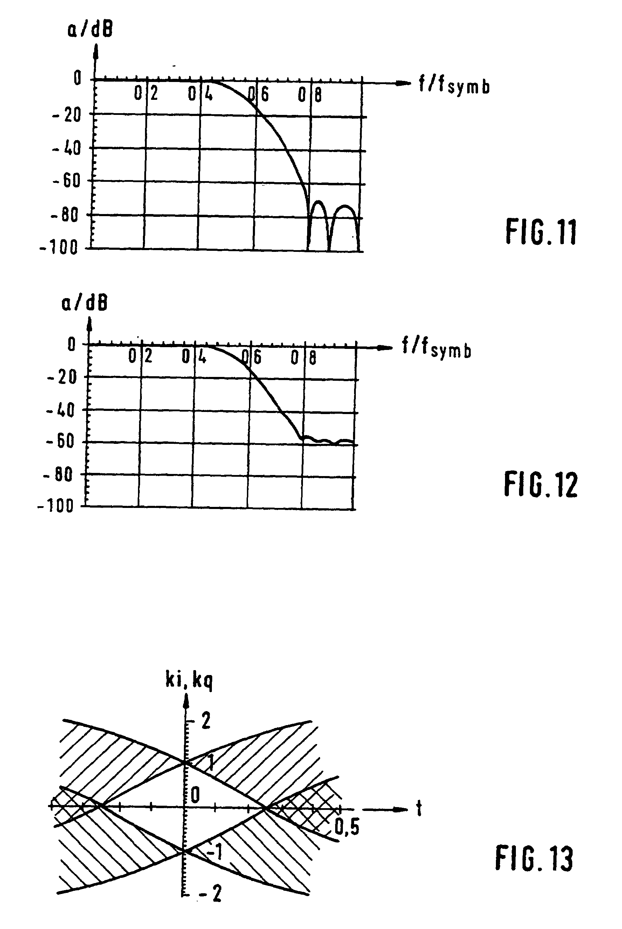

In Fig. 11 ist beispielsweise der Dämpfungsverlauf eines Empfängerfilters F2 mit Allpässen dargestellt. Die Frequenz f ist dabei auf die Symbolfrequenz fsymb normiert. Im Sperrbandbereich beträgt die Dämpfung a etwa -70 db. Das konjugiert komplexe Empfängerfilter, vgl. Gleichung (8b), müßte theoretisch den gleichen Dämpfungsverlauf aufweisen. Da wie bereits angegeben eine Allpaßrealisierung dort jedoch nicht möglich ist, wird als Senderfilter F1 eine FIR-Filterstruktur verwendet, mit der die zu spiegelnde Frequenzantwort hr(t) durch die Frequenzantwort ht(t) von Fig. 9 möglichst gut angenährt wird. Dabei muß die Impulsantwort, die sich theoretisch unendlich weit in den negativen Zeitbereich erstreckt, durch ein Zeitfenster ersetzt werden, das den zeitlichen Beginn der Impulsantwort festlegt. Dies ist voll gerechtfertigt, wenn die abgeschnittene Impulsantwort nur noch einen unbedeuteten Beitrag darstellt. Gegebenenfalls muß das Zeitfenster und die zugehörige FIR-Filterstruktur weiter vergrößert werden, bis der unterdrückte Beitrag vernachlässigbar wird. Eine Abschätzung gegenüber den bisher verwendeten FIR-Filtern F1 zeigt, daß nach der Erfindung der Filteraufwand dort lediglich um 10 bis 20 % vergrößert werden muß. Demgegenüber ist die Einsparung auf der Empfängerseite dramatisch, denn der vergleichbare Filteraufwand reduziert sich dort beispielsweise um den Faktor 10. Zudem sind die beiden Empfängerfilter FI2, FQ2 einander gleich.

Der Einfluß des eine Näherung darstellenden FIR-Filters auf die Signalübertragungseigenschaften zeigt sich im wesentlichen nur in der Sperrbanddämpfung, die in dem angenommen Beispiel von Fig. 12 etwa bei -55 dB liegt. Die Gesamtdämpfung der Filterkombination F1, F2 liefert im Sperrbandbereich eine Gesamtdämpfung, die für das gewünschte Dämpfungsverhalten mehr als ausreichend ist.

In Fig. 13 sind schematisch in einem Augendiagramm empfängerseitige Inphase- und Quadraturphase-Komponenten ki bzw. kq dargestellt. Die zum Zeitpunkt t = 0 durch die Signalwerte ki,kq = +1 und ki,kq = -1 gehenden Kurven stellen Grenzkurven dar, zwischen denen sich die empfängerseitigen Quadratursignal-Komponenten aufhalten können. Dies ist unabhängig davon, ob gerade ein Symbolübergang stattfindet oder nicht. Da sich diese Grenzkurven exakt bei den Werten +1 und -1 schneiden, ist ersichtlich, daß die Folge der vorausgehenden Symbole beliebig sein kann und keinerlei Einfluß auf die zum Zeitpunkt t = 0 zu bestimmenden Symbolzustände Si hat. Das Augendiagramm von Fig. 13, das in analoger Form die beiden Quadratur-Komponenten ki bzw. kq in allen möglichen Übergängen zwischen den Zeitpunkten $-0,5 \leq t/T_s \leq +0,5$ darstellt, ist rechnerisch aus einer asymmetrischen Filterkombination F1, F2 bestimmt, deren Dämpfungsverlauf Fig. 11 und Fig. 12 entspricht.

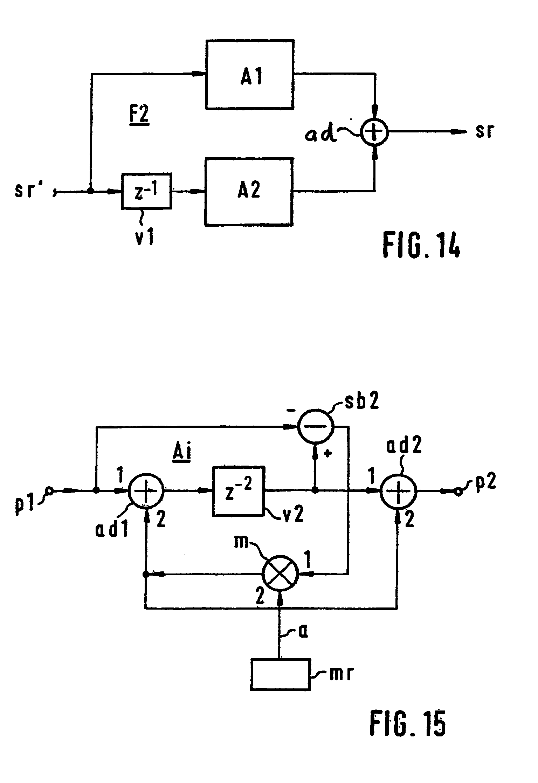

In Fig. 14 ist schematisch die Filterstruktur des Empfängerfilters F2 mit zwei Allpässen A1, A2 dargestellt. Die Struktur zeigt einen ersten Signalzweig mit dem Allpaß A1 und einen zweiten Signalzweig mit einer Serienschaltung aus einem $z^{-1}$-Verzögerer v1 und dem zweiten Allpaß A2. Der Eingang der beiden Signalzweige ist gemeinsam mit einem digitalen Eingangssignal sr' gespeist. Der Ausgang des ersten Allpasses A1 ist mit dem Subtrahendeingang und der Ausgang des zweiten Allpasses A2 ist mit dem Minuendeingang eines Subtrahierers sb1 verbunden, dessen Ausgang das digitale Ausgangssignal sr des Empfängerfilters F2 liefert.

In Fig. 15 sind schematisch die Funktionseinheiten und die zugehörige Struktur eines für die Erfindung geeigneten Allpasses Ai dargestellt. Es handelt sich dabei um einen Allpaß zweiter Ordnung, der das einfachste Ausführungsbeispiel eines Allpasses nach Gleichung (8) mit m = 2 darstellt. Ein Eingang p1 ist mit dem ersten Eingang 1 eines ersten Addierers ad1 und mit dem Subtrahendeingang eines Subtrahierers sb2 verbunden. Der Ausgang des Addierers ad2 liegt an einem $z^{-2}$-Verzögerer v2, dessen Ausgang mit dem Minuendeingang des Subtrahierers sb2 und dem ersten Eingang 1 eines zweiten Addierers ad2 verbunden ist. Am Ausgang des Subtrahierers sb2 ist der erste Eingang 1 eines Multiplizierers m angeschlosssen, dessen zweiter Eingang 2 mit einem Faktor a aus einer Speichereinrichtung mr gespeist ist. Mit dem Faktor a werden die Filtereigenschaften des Allpasses Ai bestimmt. Der Ausgang des Multiplizierers m ist sowohl mit einem zweiten Eingang 2 des ersten Addierers ad1 als auch einem zweiten Eingang 2 des zweiten Addierers ad2 verbunden, dessen Ausgang an einen Ausgang p2 angeschlossen ist. Die Filterstruktur ist damit sehr einfach und läßt sich leicht digital realisieren. Es wird darauf hingewiesen, daß die Allpaßstruktur nach Fig. 15 lediglich einen einzigen Multiplizierer m aufweist. Dem gegenüber enthalten die bisherigen FIR-Strukturen für das Empfängerfilter F2 eine Vielzahl von Multiplizierern, mit denen die einzelnen Gewichtungen der gespeicherten Signale durchzuführen sind. Unter Umständen müssen dort bis zu 40 Abtastwerte gewichtet und damit multipliziert werden. Der Vorteil einer Empfängerrealisierung mit Allpaßfiltern ist aus diesem Vergleich sofort ersichtlich. Mit Allpässen höherer Ordnung, die entsprechend Gleichung (8) ausgebildet sind, lassen sich die Filtereigenschaften bei entsprechend höherem Aufwand, der aber immer noch weit unter dem Aufwand vergleichbarer FIR-Filter liegt, verbessern. Eine digitale Realisierung des Empfängerfilters F2 oder des Senderfilters F1 ist indessen nicht zwingend, da die erfinderische Idee unabhängig vom Aufwand prinzipiell auch auf analoge Filterstrukturen angewendet werden kann.

**Patentansprüche**

1. Übertragungssystem für ein digitales Signal (sr), das in Symbole (Si) kodiert mittels einer Quadraturmodulation übertragen wird, wobei das Übertragungssystem einen Sender (T) mit Mitteln zur Quadraturmodulation und einen Empfänger (R) aufweist und wobei im Signalzweig einer der beiden Quadratursignal-Komponenten (ki, kq) im Sender vor den Mitteln zur Quadraturinodulation ein Verzögerer (13) enthalten ist, der diese Quadratursignal-Komponente (ki, kq) gegenüber der anderen Quadratursignal-Komponente um ein Zeitintervall (td) verzögert, und wobei der Sender (T) und der Empfänger (R) jeweils Impulsformfilter aufweisen,
   <u>**dadurch gekennzeichnet, dass**</u>

   - die Impulsformfilter (FI1, FQ1) im Sender (T) eine Übertragungsfunktion $H_t(z)$ aufweisen, die durch die Bestimmungsgleichung

   $$H_t(z) = 1/2 \times (1 / A_1(z^2) + z / A_2(z^2))$$

   definiert ist, wobei $A_1(z^2)$ bzw. $A_2(z^2)$ die Übertragungsfunktion eines ersten bzw. zweiten Allpassfilters zweiter Ordnung ist und die Übertragungsfunktion $H_t(z)$ durch ein FIR-Filter näherungsweise realisiert ist und

   - die Impulsfonnfilter im Empfänger (R) eine Übertragungsfunktion $H_r(z)$ aufweisen, die durch die Besfimmungsgleichung

   $$H_r(z) = 1/2 \times (A_1 (z^2) + z^{-1} 1 \times A_2(z^2))$$

   definiert ist, wobei das Impulsformfilter (FI2, FQ2) im Empfänger (R) durch ein IIR-Filter realisiert ist.

2. Übertragungssystem nach Anspruch 1, **dadurch gekennzeichnet, dass** das vom Verzögerer (13) abhängige Zeitintervall (td) ein Viertel einer Symbol periode $T_{symb}$ oder ein Viertel der Periode eines der Quadratursignalübertragung zugrunde liegenden Quadraturträgers (tr) im Sender (T) ist.

3. Sender (T) für ein Übertragungssystem gemäß Anspruch 2, mit
   einem Seriell/Parallel-Umsetzer (3), derart ausgestaltet, dass er aus dem mit einer Bitrate $f_{Bit}$ verknüpften digitalen Signal (sr), das von einer Datenquelle (1) geliefert ist, einen I- und einen Q-Datenstrom (I, Q) bildet,
   einem jeweils als Impulsfonnfilter dienenden ersten Inphase- und ersten Quadraturphase-Filter (FI1, FQ1), um den I- und Q-Datenstrom (I, Q) in der Bandbreite zu begrenzen, wodurch eine Inphase- und eine Quadraturphase-Komponente (ki, kq) entstehen,
   einen Sender-Quadraturmischer (4), der so ausgestaltet ist, dass er mit der Inphase- und der Quadraturphase-Komponente (ki, kq) einen Quadraturträger (tr) moduliert, und
   einer Verzögerungseinrichtung (13), die vor dem Sender-Quadraturmischer (4) entweder die Inphase- oder die Quadraturphase-Komponente (ki, kq) um ein Zeitintervall (td) verzögert, das einem ganzzahligen Teil 1/N der Symbolperiode $T_{symb}$ gleich ist,
   <u>dardurch</u> **gekennzeichnet,**
   dass im Sender Impulsformfilter (FI1, FQ1) vorhanden sind, deren Übertragungsfunktion $H_t(z)$ durch die Bestimmungsgleichung

   $$H_t(z) = 1/2 \times ( 1 / A_1(z^2) + z / A_2(z^2))$$

   definiert ist, wobei $A_1(z^2)$ bzw. $A_2(z^2)$ die Übectragungsfunktion eines ersten bzw. zweiten Allpassfilters zweiter Ordnung ist, wobei die Übertragungsfunktion $H_t(z)$ durch ein FIR-Filter näherungsweise realisiert ist.

4. Empfänger (R) für ein Übertragungssystem gemäß Anspruch 2, mit
   einem Analog/Digital-Umsetzer (17) zur Bildung eines abgetasteten Signals (sd) aus einem empfangenen Signal (s(t)), wobei die Abtastfrequenz fs des Analog/Digital-Umsetzers (17) im wesentlichen der vierfachen Symbolfrequenz $f_{symb}$ entspricht,
   einem Demultiplexer (81), der so ausgestaltet ist, dass er aus dem abgetasteten Signal (sd) für einen I-Datenpfad (I) eine Inphase-Komponente (ki) und für einen Q-Datenpfad (Q) eine Quadraturphase-Komponente (kq) bildet,

**dadurch gekennzeichnet, dass**
der Empfänger (R) Impulsformfilter aufweist,
die Impulsformfilter im Empfänger (R) eine Übertragungsfunktion $H_T(z)$ aufweisen, die durch die Bestimmungsgieichung

$$H_r(z) = 1/2 \times ( A_1(z^2) + z^{-1} \times A_2(z^2))$$

definiert ist, wobei $A_1(z^2)$ bzw. $A_2(z^2)$ die Übertragungsfunktion eines ersten bzw. zweiten Allpassfilters zweiter Ordnung ist, die Impulsformfilter jeweils mittels eines IIR-Filters realisiert sind, und
eine Taktrückgewinnungseinrichtung (11) vorhanden ist, die eingangsseitig mit dem I- und /oder Q-Datenpfad (I, Q) und ausgangsseitig mit dem Analog/Digital-Umsetzer (17), dem Demultiplexer (81) und einem Quadraturmischer (80, 85) gekoppelt ist.

5. Empfänger (R) nach Anspruch 4, **dadurch gekennzeichnet, dass** das zweite Inphase-Filter (FI2) bzw. Quadraturphase-Filter (FQ2) zwei parallele Signalzweige aufweist, die eingangsseitig miteinander verbunden sind und ausgangsseitig mittels eines Addierers (ad) zusammengeschaltet sind, wobei der eine Signalzweig den ersten Allpass (A1) und der zweite Signalzweig eine Serienschaltung aus einem $z^{-1}$-Verzögerer (v1) und dem zweiten Allpass (A2) enthält.

6. Empfänger (R) nach einem der Ansprüche 4 oder 5, **dadurch gekennzeichnet, dass** die Impulsfomifilter als Funktionseinheiten einen $z^2$-Verzögerer (v2), einen Multiplizierer (m), einen ersten und zweiten Addierer (ad1, ad2) und einen zweiten Subtrahierer (sb2) enthalten.

7. Empfänger (R) nach Anspruch 6, **dadurch gekennzeichnet, dass** die Funktionseinheiten wie folgt miteinander verbunden sind:

eine Serienschaltung zwischen einem Eingang (p1) und einem Ausgang (p2) enthält in Signalflußrichtung den am ersten Eingang (1) angeschlossenen ersten Addierer (ad1), den $z^2$-Verzögerer (v2) und den am ersten Eingang (1) angeschlossenen zweiten Addierer (ad2),

der zweite Subtrahierer (sb2) ist über seinen Subtrahendeingang mit dem Eingangsanschluss (p1), über seinen Minuendeingang mit dem Ausgang des $z^2$-Verzögerers (v2) und über seinen Ausgang mit dem ersten Eingang (1) des Multiplizierers (m) verbunden, und

der zweite Eingang (2) des Multiplizierers (m) ist aus einem Speicher (mr) mit einem Filterfaktor a gespeist und der Ausgang des Multiplizierers (m) ist sowohl mit dem zweiten Eingang (2) des ersten Addierers (ad1) als auch mit dem zweiten Eingang (2) des zweiten Addierers (ad2) verbunden.

**Claims**

1. A transmission system for a digital signal (sr) which, encoded into symbols (Si), is transmitted using quadrature modulation, the transmission system comprising a transmitter (T) with means for quadrature modulation and a receiver (R), the signal branch for one of the two quadrature signal components (ki, kq) in the transmitter containing, ahead of the means for quadrature modulation, a delay element (13) which delays this quadrature signal component (ki, kq) by a given time interval (td) with respect to the other quadrature signal component, and the transmitter (T) and the receiver (R) each comprising pulse-shaping filters,
**characterized in**

- **that** the pulse-shaping filters (FI1, FQ1) in the transmitter (T) have a transfer function $H_t(z)$ defined by

$$H_t(z) = 1/2 \text{ x } (1/A_1 (z^2) + z/A_2 (z^2)) ,$$

where $A_1(z^2)$ and $A_2(z^2)$ are the transfer functions of a first second-order all-pass filter and a second second-order all-pass filter, respectively, and wherein the transfer function $H_t(z)$ is implemented using an FIR filter approximation, and

- **that** the pulse-shaping filters (FI2, FQ2) in the receiver (R) have a transfer function $H_r(z)$ defined by the equation

$$H_t(z) = 1/2 \times (A_1(z^2) + z^{-1} \times A_2(z^2))$$

and are implemented using IIR filters.

2. A transmission system as claimed in claim 1, **characterized in that** the time interval (td) determined by the delay element (13) is one quarter of a symbol period $T_{symb}$ or one quarter of the period of a quadrature carrier (tr) in the transmitter (T) on which the quadrature transmission is based.

3. A transmitter (T) for a transmission system as claimed in claim 2, comprising:

a serial-to-parallel converter (3) which converts the digital signal (sr), which is provided by a data source (1) and is locked to a bit rate $f_{Bit}$, into an I data stream (I) and a Q data stream (Q);

a first in-phase filter (FI1) and a first quadrature filter (FQI), each serving as a pulse-shaping filter, for limiting the bandwidth of the I and Q data streams (I, Q) to form an in-phase component (ki) and a quadrature component (kq);

a transmitter quadrature mixer (4) adapted to modulate a quadrature carrier (tr) with the in-phase component (ki) and the quadrature component (kg); and

a delay element (13) which is connected ahead of the transmitter quadrature mixer (4) and delays either the in-phase component (ki) or the quadrature component (kq) by a time interval (td) equal to an integral part 1/N of the symbol period $T_{symb}$,

**characterized in**
**that** the transmitter comprises pulse-shaping filters (FI1, FQ1) whose transfer function $H_t(z)$ is defined by

$$H_t(z) = 1/2 \times (1/A_1(z^2) + z/A_2(z^2)),$$

where $A_1(z^2)$ and $A_2(z^2)$ are the transfer functions of a first second-order all-pass filter and a second second-order all-pass filter, respectively, the transfer function $H_t(z)$ being implemented using an FIR filter approximation.

4. A receiver (R) for a transmission system as claimed in claim 2, comprising:

an analog-to-digital converter (17) for forming a sampled signal (sd) from a received signal (s(t)), with the sampling frequency fs of the analog-to-digital converter (17) being substantially equal to four times the symbol frequency $f_{symb}$; and

a demultiplexer (81) adapted to separate the sampled signal (sd) into an in-phase component (ki) for an I data path (I) and a quadrature component (kq) for a Q data path (Q),

**characterized in**
**that** the receiver (R) comprises pulse-shaping filters,
**that** the pulse-shaping filters in the receiver (R) have a transfer function $H_r(z)$ defined by

$$H_r(Z) = 1/2 \times (A_1(z^2) + z^{-1} \times A_2(z^2)),$$

where $A_1(z^2)$ and $A_2(z^2)$ are the transfer functions of a first second-order all-pass filter and a second second-order all-pass filter, respectively, each of the pulse-shaping filters being implemented with an IIR filter, and
**that** a clock recovery device (11) is provided which is coupled at its input end to the I data path (I) and/or the Q data path (Q) and at its output end to the analog-to-digital converter (17), to the demultiplexer (81), and to a quadrature mixer (80, 85).

5. A receiver (R) as claimed in claim 4 **characterized in that** the second in-phase filter (FI2) and the second quadrature filter (FQ2) have two parallel signal paths which are coupled together at the input end, and which are connected together at the output end by means of an adder (ad), with the one of the signal paths containing the first all-pass network (A1), and the second signal path containing a series combination of a $z^{-1}$ delay element (v1) and the second all-pass network (A2).

6. A receiver (R) as claimed in claim 4 or 5, **characterized in that** the pulse-shaping filters contain a $z^{-2}$ delay element (v2), a multiplier (m), a first adder (ad1), a second adder (ad2), and a second subtracter (sb2) as functional units.

7. A receiver (R) as claimed in claim 6, **characterized in that** the functional units are interconnected as follows:

a series combination between an input terminal (p1) and an output terminal (p2) contains, in the direction of signal flow, the first adder (ad1), which has its first input (1) connected to the input terminal (p1), as well as the $z^{-2}$ delay element (v2) and the second adder (ad2), which has its first input (1) connected to the output of the $z^{-2}$ delay element (v2);

the second subtracter (sb2) is connected to the input terminal (p1) via its subtrahend input, to the output of the $z^{-2}$ delay element (v2) via its minuend input, and to the first input (1) of the multiplier (m) via its output; and

the second input (2) of the multiplier (m) is fed with a filter factor a from a memory (mr), and the output of the multiplier (m) is connected both to the second input (2) of the first adder (ad1) and to the second input (2) of the second adder (ad2).

**Revendications**

1. Système de transmission pour un signal numérique (sr) qui est codé par des symboles (Si) et qui est transmis, au moyen d'une modulation en quadrature, dans lequel le système de transmission comporte un émetteur (T) équipé de moyens pour la modulation en quadrature et un récepteur (R) et dans lequel, dans l'émetteur (T), le trajet de signal d'une des deux composantes du signal en quadrature (ki, kq) contient, avant les moyens pour la modulation en quadrature, un dispositif à retard (13) qui retarde cette composante du signal en quadrature (ki, kq) par rapport à l'autre composante du signal en quadrature (ki, kq) d'un intervalle de temps (td) et dans lequel l'émetteur (T) et le récepteur (R) comportent chacun des filtres de formation des impulsions,
   **caractérisé en ce que** :

les filtres de formation des impulsions (FI1, FQ1) qui se trouvent dans l'émetteur (T) comportent une fonction de transfert Ht(z) qui est définie par l'équation de détermination suivante :

$$H_t(z) = 1/2 \text{ x } (1 / A_1(z^2) + z / A_2(z^2))$$

dans laquelle $A_1(z^2)$, respectivement $A_2(z^2)$, est la fonction de transfert d'un premier, respectivement deuxième, filtre passe-tout du deuxième ordre et la fonction de transfert Ht(z) est réalisée de manière approchée au moyen d'un filtre à réponse impulsionnelle finie (FIR) et
   les filtres de formation des impulsions qui se trouvent dans le récepteur comportent une fonction de transfert Hr(z) qui est définie par l'équation de détermination suivante :

$$H_r(z) = 1/2 \times (A_1(z^2) + z^{-1} \text{ x } A_2(z^2))$$

le filtre de formation des impulsions (FI2, FQ2) étant réalisé sous la forme d'un filtre à réponse impulsionnelle infinie (IIR).

2. Système de transmission selon la revendication 1, **caractérisé en ce que** l'intervalle de temps (td) qui dépend par du dispositif à retard (13) est égal à un quart de la période des symboles $T_{symb}$ ou un quart de la période d'une porteuse de quadrature t(r) qui se trouve dans l'émetteur (T) et qui est à la base de la transmission du signal en quadrature.

**3.** Emetteur (T) pour un système de transmission selon la revendication 2, comportant :

un convertisseur série/parallèle (3) qui est conformé de manière à former, à partir du signal numérique (sr) qui est lié à un débit de bits fBit et qui est fourni par une source de données (1), un flux de données I et un flux de données Q (I, Q),

un premier filtre en phase et un premier filtre en quadrature (FI1, FQ1) qui servent chacun de filtre de formation des impulsions, pour limiter la largeur de bande du flux de données I et du flux de données Q (I, Q), grâce à quoi on crée une composante en phase et une composante en quadrature (ki, kq),

un mélangeur en quadrature de l'émetteur (4) qui est conformé de manière à moduler la porteuse de quadrature t(r) par la composante en phase et la composante en quadrature (ki, kq), et

un dispositif à retard (13) qui retarde, avant le mélangeur en quadrature de l'émetteur (4), soit la composante en phase (ki), soit la composante en quadrature (kq) d'un intervalle de temps (td).qui est égal à une fraction par un nombre entier 1/N de la période des symboles $T_{symb}$,

**caractérisé en ce que**

on prévoit, dans l'émetteur (T), des filtres de formation des impulsions (FI1, FQ1) dont la fonction de transfert Ht(z) est définie par l'équation de détermination suivante :

$$H_t(z) = 1/2 \times (1 / A_1(z^2) + z / A_2(z^2))$$

dans laquelle $A_1(z^2)$, respectivement $A_2(z^2)$, est la fonction de transfert d'un premier, respectivement deuxième, filtre passe-tout du deuxième ordre et dans laquelle la fonction de transfert Ht(z) est réalisée de manière approchée au moyen d'un filtre à réponse impulsionnelle finie (FIR).

**4.** Récepteur (R) pour un système de transmission selon la revendication 2, comportant :

un convertisseur analogique-numérique (17) pour la formation d'un signal échantillonné (sd) à partir d'un signal reçu (s(t)), la fréquence d'échantillonnage fs du convertisseur analogique-numérique (17) correspondant, pour l'essentiel, au quadruple de la fréquence des symboles $f_{symb}$, et

un démultiplexeur (81) qui est conformé de manière à former, à partir du signal échantillonné (sd), pour un trajet de données I (I) une composante en phase (ki) et pour un trajet de données Q (Q) une composante en quadrature (qi),

**caractérisé en ce que**

le récepteur (R) comporte des filtres de formation des impulsions

les filtres de formation des impulsions qui se trouvent dans le récepteur (R) comportent une fonction de transfert Hr(z) qui est définie par l'équation de détermination suivante :

$$H_r(z) = 1/2 \times (A_1(z^2) + z^{-1} \times A_2(z^2))$$

dans laquelle A1(z2), respectivement A2(z2), est la fonction de transfert d'un premier, respectivement deuxième, filtre passe-tout du deuxième ordre et dans laquelle les filtres de formation des impulsions sont réalisés chacun au moyen d'un filtre à réponse impulsionnefle infinie (IIR) et

on prévoit un dispositif de récupération du cadencement (11) qui est relié, du côté de son entrée, avec le trajet de données I et/ou le trajet de données Q (I, Q) et, du côté de sa sortie, avec le convertisseur analogique-numérique (17), le démultiplexeur (81) et un mélangeur en quadrature (80, 85).

**5.** Récepteur (R) selon la revendication 4, **caractérisé en ce que** le deuxième filtre en phase (FI2), respectivement le deuxième filtre en quadrature (FQ2), comporte deux branches de signal en parallèle qui, du côté de leur entrée, sont reliées entre elles et, du côté de leur sortie, sont commutées ensemble au moyen d'un additionneur (ad) et **en ce que** l'une des branches de signal contient le premier filtre passe-tout (A1) et la deuxième branche de signal contient un circuit série constitué d'un dispositif à retard $z^{-1}$ (v1) et du deuxième filtre passe-tout (A2).

**6.** Récepteur (R) selon l'une des revendications 4 ou 5, **caractérisé en ce que** les filtres de formation des impulsions contiennent, en tant qu'unités fonctionnelles, un dispositif à retard $z^2$ (v2), un multiplicateur (m), un premier et un deuxième additionneur (ad1, ad2) et un deuxième circuit soustracteur (sb2).

**7.** Récepteur (R) selon la revendication 6, **caractérisé en ce que** les unités fonctionnelles sont reliées entre elles de la manière suivante :

un circuit série qui est disposé entre une entrée (p1) et une sortie (p2) contient, dans le sens du flux du signal, le premier additionneur (ad1) qui est branché sur sa première entrée (1), le dispositif à retard z2 (v2) et le deuxième additionneur (ad2) qui est branché sur sa première entrée (1),
le deuxième circuit soustracteur (sb2) est relié, par son entrée de soustraction, à la connexion d'entrée (p1), par son entrée de diminuende, à la sortie du dispositif à retard $z^2$ (v2) et, par sa sortie, à la première entrée (1) du multiplicateur (m), et
la deuxième entrée (2) du multiplicateur (m) est alimentée par un facteur de filtrage a qui provient d'une mémoire (mr) et la sortie du multiplicateur (m) est aussi reliée à la deuxième entrée (2) du deuxième additionneur (ad2).

**FIG.1**

**FIG. 2**

| Bitpaar | | | | |
|---|---|---|---|---|
| d1 | d2 | I | Q | Si |
| 0 | 0 | -1 | -1 | 0 = S0 |
| 0 | 1 | -1 | 1 | 1 = S1 |
| 1 | 0 | 1 | -1 | 2 = S2 |
| 1 | 1 | 1 | 1 | 3 = S3 |

**FIG. 3**

**FIG. 4**

**FIG. 5**

FIG. 6

FIG. 7

hr(t)

**FIG. 8**

ht(t)

= h'r (- t)

**FIG. 9**

hg(t)

**FIG. 10**

FIG.11

FIG.12

FIG.13

FIG.14

FIG.15